# EUROPEAN PATENT APPLICATION

(11) **EP 4 793 990 A1**
(43) Date of publication of application: **19.08.2026**
(21) Application number: 24877095.0
(22) Date of filing: 03.10.2024
(51) Int. Cl.: H01L 21/52

(54) **SEMICONDUCTOR DEVICE MANUFACTURING METHOD**

(30) Priority: 12.10.2023 JP 2023176786
(71) Applicant: Central Glass Company, Limited, Ube-shi, Yamaguchi 755-0001 (JP)
(72) Inventor: TAKASAKI, Mikihiro, Tokyo 101-0054 (JP); KIDA, Takahisa, Tokyo 101-0054 (JP); YOSHIMURA, Ryota, Tokyo 101-0054 (JP); HAMADA, Jun, Tokyo 101-0054 (JP)
(74) Representative: Mewburn Ellis LLP
(86) International application number: PCT/JP2024/035462
(87) International publication number: WO 2025/079497

(57) **Abstract**

Provided is a method for producing a semiconductor device, which can reduce misalignment of a component to be bonded, such as a semiconductor chip. The present invention relates to a method for producing a semiconductor device, including: a dry film formation step including drying a paste containing a metal and/or a metal oxide formed on a component A to be bonded, to form a dry film having a storage elastic modulus of 15 GPa or less; and a temporary bonding step including temporarily bonding a component B to be bonded to the component A to be bonded via the dry film formed in the dry film formation step.

## Description

### TECHNICAL FIELD

The present invention relates to a method for producing a semiconductor device.

### BACKGROUND ART

Silver- or copper-containing bonding materials are widely known as bonding materials for semiconductor materials. In particular, nano-sized silver-based materials have recently been investigated as bonding materials for semiconductor materials.

As an example in which a nano-sized silver-based material is used as a bonding material for semiconductor materials, mention may be made of a semiconductor device in which a semiconductor chip is mounted, via a silver- or copper-containing bonding material, on the main surface of a conductive plate such as a conductive pattern layer of an insulating circuit board or a lead frame. The production of such a semiconductor device includes, for example, placing a semiconductor chip on the main surface of a conductive plate via a bonding material, and then temporarily bonding the semiconductor chip through pressing and heating. Then, after a preparation step such as transportation of the conductive plate (e.g., insulating circuit board or lead frame) with the semiconductor chip temporarily bonded thereto, the bonding material is sintered through pressing and heating, so that the semiconductor chip is permanently bonded to the conductive plate via the bonding material.

During the period from the placement of a semiconductor chip on a conductive plate, through temporary bonding, to permanent bonding, misalignment of the semiconductor chip can occur, for example, in the preparation step or when an upper electrode comes into contact with the semiconductor chip. If the semiconductor chip in misalignment is permanently bonded, for example, failure (e.g., connection failure) may occur in the subsequent connection between the semiconductor chip and other components (e.g., conductive wires, clips, blocks, circuit boards, or other components), which may cause a decrease in the yield or quality of the resulting semiconductor device.

As a technique to solve the above problem, Patent Literature 1 discloses that misalignment of a semiconductor chip may be reduced by preliminarily treating a surface to be adhered to a bonding material, such as the main surface of a conductive plate.

### CITATION LIST

### - Patent Literature

Patent Literature 1: JP 2023-094270 A

### SUMMARY OF INVENTION

### - Technical Problem

If the method for producing a semiconductor device is likely to cause misalignment of the semiconductor chip in the preparation step, a semiconductor device with the semiconductor chip in misalignment is likely to be formed by the immediately subsequent permanent bonding, leading to a decrease in production yield. Although the method of Patent Literature 1 can reduce misalignment of a semiconductor chip, the method needs to preliminarily treat a surface to be adhered to a bonding material, which may result in a decrease in productivity. Thus, there is still a need for other techniques.

The present disclosure aims to solve the problem and provide a method for producing a semiconductor device, which can reduce misalignment of a component to be bonded, such as a semiconductor chip.

### - Solution to Problem

With a view to developing nano-sized silver-based materials for use as bonding materials, the present inventors conducted an extensive investigation focusing on the various physical properties of a paste containing a metal and/or a metal oxide and a film obtained from the paste. As a result, they have found that a dry film having specific physical properties may be used as a bonding material to reduce misalignment of a component to be bonded, such as a semiconductor chip.

The present disclosure includes the following embodiments.

Embodiment (1) of the present disclosure relates to a method for producing a semiconductor device, including:
a dry film formation step including drying a paste containing at least one of a metal or a metal oxide formed on a component A to be bonded, to form a dry film having a storage elastic modulus of 15 GPa or less; and
a temporary bonding step including temporarily bonding a component B to be bonded to the component A to be bonded via the dry film formed in the dry film formation step.

Embodiment (2) of the present disclosure relates to the method for producing a semiconductor device according to Embodiment (1) of the present disclosure, wherein the dry film formation step includes drying the paste containing at least one of a metal or a metal oxide formed on the component A to be bonded, to form the dry film having a storage elastic modulus that is 4.0 GPa or more and 12 GPa or less.

Embodiment (3) of the present disclosure relates to the method for producing a semiconductor device according to Embodiment (1) of the present disclosure, wherein the dry film formation step includes drying the paste containing at least one of a metal or a metal oxide formed on the component A to be bonded, to form the dry film having a storage elastic modulus that is 5.0 GPa or more and 10 GPa or less.

Embodiment (4) of the present disclosure relates to the method for producing a semiconductor device according to any one of Embodiments (1) to (3) of the present disclosure, wherein the temporary bonding step includes heating the component B to be bonded that is in contact with the dry film formed on the component A to be bonded in the dry film formation step, thereby temporarily bonding the component B to be bonded to the component A to be bonded via the dry film.

Embodiment (5) of the present disclosure relates to the method for producing a semiconductor device according to any one of Embodiments (1) to (3) of the present disclosure, wherein the temporary bonding step includes pressing and heating the component B to be bonded that is in contact with the dry film formed on the component A to be bonded in the dry film formation step, thereby temporarily bonding the component B to be bonded to the component A to be bonded via the dry film.

Embodiment (6) of the present disclosure relates to the method for producing a semiconductor device according to any one of Embodiments (1) to (3) of the present disclosure, wherein the temporary bonding step includes placing the component B to be bonded on a surface of the dry film formed on the component A to be bonded in the dry film formation step, the surface being on a side opposite to the component A to be bonded, followed by temporarily bonding the component B to be bonded to the component A to be bonded via the dry film by heating.

Embodiment (7) of the present disclosure relates to the method for producing a semiconductor device according to any one of Embodiments (1) to (3) of the present disclosure, wherein the temporary bonding step includes placing the component B to be bonded on a surface of the dry film formed on the component A to be bonded in the dry film formation step, the surface being on a side opposite to the component A to be bonded, followed by temporarily bonding the component B to be bonded to the component A to be bonded via the dry film by pressing and heating.

Embodiment (8) of the present disclosure relates to the method for producing a semiconductor device according to any one of Embodiments (1) to (7) of the present disclosure, wherein the dry film contains silver oxide particles, silver particles, or both.

Embodiment (9) of the present disclosure relates to the method for producing a semiconductor device according to any one of Embodiments (1) to (7) of the present disclosure, wherein the dry film contains silver oxide particles.

Embodiment (10) of the present disclosure relates to the method for producing a semiconductor device according to any one of Embodiments (1) to (9) of the present disclosure, further including a permanent bonding step including permanently bonding the component B to be bonded to the component A to be bonded by heating after temporarily bonding the component B to be bonded to the component A to be bonded in the temporary bonding step.

Embodiment (11) of the present disclosure relates to the method for producing a semiconductor device according to Embodiment (10) of the present disclosure, wherein the temporary bonding step includes temporarily bonding the component B to be bonded to the component A to be bonded via the dry film by heating, and
a temperature in the permanent bonding step is higher than a temperature in the temporary bonding step.

Embodiment (12) of the present disclosure relates to the method for producing a semiconductor device according to Embodiment (10) or (11) of the present disclosure, wherein the temporary bonding step includes temporarily bonding the component B to be bonded to the component A to be bonded via the dry film by pressing and heating,
the permanent bonding step includes permanently bonding the component B to be bonded to the component A to be bonded by pressing and heating after temporarily bonding the component B to be bonded to the component A to be bonded in the temporary bonding step, and
a pressure in the permanent bonding step is higher than a pressure in the temporary bonding step.

Embodiment (13) of the present disclosure relates to the method for producing a semiconductor device according to any one of Embodiments (10) to (12) of the present disclosure, wherein the temporary bonding step is performed in air, and the permanent bonding step is performed in an inert gas atmosphere.

Embodiment (14) of the present disclosure relates to the method for producing a semiconductor device according to any one of Embodiments (1) to (13) of the present disclosure, further including an application step including applying the paste containing at least one of a metal or a metal oxide onto the component A to be bonded,
wherein the dry film formation step includes drying the paste containing at least one of a metal or a metal oxide applied in the application step to form the dry film on the component A to be bonded.

Embodiment (15) of the present disclosure relates to the method for producing a semiconductor device according to any one of Embodiments (1) to (14) of the present disclosure, wherein the component A to be bonded is a substrate, and the component B to be bonded is a semiconductor chip.

### - Advantageous Effects of Invention

The method for producing a semiconductor device according to the present disclosure includes a dry film formation step including drying a paste containing a metal and/or a metal oxide formed on a component A to be bonded, to form a dry film having a storage elastic modulus of 15 GPa or less; and a temporary bonding step including temporarily bonding a component B to be bonded to the component A to be bonded via the dry film formed in the dry film formation step. Thus, the present disclosure can provide a method for producing a semiconductor device, which can reduce misalignment of a component to be bonded, such as a semiconductor chip.

### BRIEF DESCRIPTION OF DRAWINGS

FIG. 1 (a) is a schematic diagram schematically showing an example of a paste containing a metal and/or a metal oxide formed on a component A to be bonded. FIG. 1 (b) is a schematic diagram schematically showing an example of a dry film formed on the component A to be bonded.
FIG. 2(a) and FIG. 2(b) are schematic diagrams each schematically showing an exemplary placement of a component B to be bonded.
FIG. 3 (a) is a schematic diagram schematically showing an exemplary behavior during pressing in a temporary bonding step. FIG. 3 (b) is a schematic diagram schematically showing an example of a component to be bonded after a temporary bonding step. FIG. 3 (c) is a schematic diagram schematically showing an example of a component to be bonded after a permanent bonding step.
FIG. 4 is a schematic diagram schematically showing an example of a cross-section of a dry film.
FIG. 5 shows drawing-substituting photographs of a surface and a cross-section of a dry film when using flake-shaped silver oxide particles.
FIG. 6 is a schematic diagram schematically showing an example of a cross-section of a temporarily bonded dry film when using flake-shaped silver oxide particles.
FIG. 7 is a schematic diagram schematically showing an example of a cross-section of a permanently bonded dry film when using flake-shaped silver oxide particles.

### DESCRIPTION OF EMBODIMENTS

Hereinafter, the present disclosure will be described in detail, but the description of the constituent elements described below illustrates embodiments of the present disclosure, and the present disclosure is not limited to these specific contents. Various modifications may be made within the scope of its gist.

Herein, the expression "X to Y" in the description of a numerical range indicates "X or more and Y or less", unless otherwise stated. For example, "1 to 5 mass%" means "1 mass% or more and 5 mass% or less".

The method for producing a semiconductor device of the present disclosure includes a dry film formation step including drying a paste containing a metal and/or a metal oxide formed on a component A to be bonded, to form a dry film having a storage elastic modulus of 15 GPa or less; and a temporary bonding step including temporarily bonding a component B to be bonded to the component A to be bonded via the dry film formed in the dry film formation step. This can provide a method for producing a semiconductor device, which can reduce misalignment of a component to be bonded, such as a semiconductor chip.

Although the reason for the above-described advantageous effect is not exactly clear, the advantageous effect is presumably due to the following mechanism.

A temporary bonding step generally involves bonding at a lower temperature and a lower pressure for a shorter time than a permanent bonding step, and therefore tends not to provide strong fixing. In contrast, according to the present disclosure, the dry film has a specified storage elastic modulus and thus can readily conform to the surface shapes of the components A and B to be bonded, thereby increasing the contact areas with the components A and B to be bonded and resulting in wide-range, overall surface contact between the dry film and the surfaces of the components A and B to be bonded. Accordingly, temporary bonding allows for wide-range, overall surface bonding, and the component B to be bonded can be relatively firmly fixed to the component A to be bonded via the dry film even in temporary bonding. Presumably for this reason, it is possible to reduce misalignment of a component to be bonded, such as a semiconductor chip.

Non-limiting examples of the components A and B to be bonded include components used in semiconductor devices, such as substrates, semiconductor chips, heat sinks, spacers, and electrodes. Each of these may be used alone, or two or more of these may be used in combination. Moreover, the components A and B to be bonded may be components of the same type. For example, both the component A to be bonded and the component B to be bonded may be substrates. In particular, the component A to be bonded is a substrate and the component B to be bonded is a semiconductor chip, preferably a power semiconductor chip, because, during the period from the placement of a semiconductor chip on a substrate, through temporary bonding, to permanent bonding in a semiconductor device production method, misalignment of the semiconductor chip often occurs, whereas the production method of the present disclosure can more suitably reduce such misalignment.

The shapes and sizes of the components A and B to be bonded are not limited.

In the method for producing a semiconductor device of the present disclosure, the component B to be bonded is temporarily bonded to the component A to be bonded. Accordingly, for example, the outermost surface or the like of a substrate or a semiconductor chip serves as a surface to be bonded. The material of the surface to be bonded of the component to be bonded is preferably at least one selected from the group consisting of Si, SiO₂, SiN, SiC, AlOₓ, AlNₓ, HfOₓ, ZrOₓ, TiN, TaN, Ti, Co, Ru, Ta, Cu, CuOₓ, and W because these materials are widely used for the production of semiconductor devices. More preferably, the material is at least one selected from the group consisting of Si, SiO₂, SiN, SiC, AlOₓ, AlNₓ, Cu, and CuOₓ. The material may also be Ni or Ag. Each of these materials may be used alone, or two or more of these may be used in combination.

Herein, the term "AlOₓ" means an oxide of aluminum. The same applies to the meanings of other similar terms.

The component to be bonded may undergo surface treatment such as silane coupling treatment, silazane treatment, organic thin film coating, self-assembled monolayer (SAM) treatment, plating treatment, or other surface metallization treatments. Each of these surface treatments may be used alone, or two or more of these may be used in combination.

Non-limiting examples of the substrate include semiconductor device substrates such as silicon substrates, compound semiconductor substrates, ceramic substrates, glass substrates, and metal substrates. The substrate may also have a metal or metal oxide film. Specifically, the substrate may be, for example, a semiconductor device substrate having a metal or metal oxide film in its structure, or a substrate on which a metal or a metal oxide is formed during patterning of a semiconductor device.

Non-limiting examples of the semiconductor chip include silicon chips, compound semiconductor chips, and semiconductor package chips. Specifically, suitable examples include semiconductor chips used in power semiconductors, such as Si semiconductor chips, SiC semiconductor chips, GaN semiconductor chips, Ga₂O₃ semiconductor chips, and AlGaN semiconductor chips. In particular, Si, SiC, GaN, or Ga₂O₃ semiconductor chips are preferred.

Herein, the term "silicon" may refer to either polycrystalline silicon or monocrystalline silicon.

The following will describe an example of a method for producing a semiconductor device of the present disclosure.

### <Application step>

An application step includes applying a paste containing a metal and/or a metal oxide onto a component A to be bonded. Through this step, a layer of the paste containing a metal and/or a metal oxide is formed on the component A to be bonded.

The paste containing a metal and/or a metal oxide may be applied on the component A to be bonded by various printing methods. Non-limiting examples of the printing methods include screen printing, dispensing, and applicator coating.

The paste is preferably applied in an amount that gives a dry thickness of, for example, 10 to 100 µm, preferably 20 to 50 µm.

### (Paste containing metal and/or metal oxide)

Next, the paste containing a metal and/or a metal oxide will be described.

The paste containing a metal and/or a metal oxide may be any paste that contains metal particles and/or metal oxide particles. Metal oxide particles are preferred among the metal particles and metal oxide particles.

Non-limiting examples of the metal particles include silver particles, copper particles, gold particles, and nickel particles. Each of these may be used alone, or two or more of these may be used in combination. Silver particles are preferred among these.

Non-limiting examples of the metal oxide particles include particles of oxides of the foregoing metals. Each of these may be used alone, or two or more of these may be used in combination. Silver oxide particles are preferred among these because they possess reducibility and sinterability at low temperatures and thus allow for relatively firm bonding (fixation) even in temporary bonding, which often involves bonding at a lower temperature and a lower pressure for a shorter time than permanent bonding.

In order to more suitably form a dry film having a storage elastic modulus specified in the present application, the metal particles and/or metal oxide particles are preferably flake-shaped metal particles and/or metal oxide particles, more preferably flake-shaped metal particles and/or metal oxide particles having an average thickness of 1 to 100 nm and a D50 of 100 to 350 nm. For the same reason, the metal particles and/or metal oxide particles are preferably silver oxide particles. The investigation by the present inventors have revealed that using the above-described flake-shaped silver oxide particles instead of conventional spherical silver oxide particles tends to provide good bonding strength even at low temperatures.

Herein, the term "flake shape" refers to a morphology that is non-spherical and has at least an upper surface, a lower surface, and a thickness, with the upper and lower surfaces being substantially flat. Here, the upper and lower surfaces may be partially uneven or deformed. It suffices that the shape, when viewed as a whole, is a flat plate or a rectangular parallelepiped with a small thickness (i.e., a thickness smaller than the length). The term may also refer to a flat plate-like shape, such as a thin slice or a scale (flaky shape: "plate-like shape" described in JIS Z 2500:2000).

More specifically, according to the method described later for measuring the average thickness, a sample that can be observed from the cross-sectional direction of particles is provided and observed by a scanning electron microscope. When the distance between the upper and lower surfaces of the central part of a particle is taken as the thickness of the particle, the particle may be determined to have a flake shape if the length of a side intersecting the thickness direction of the particle is greater than the thickness.

The average thickness (average of thicknesses) of the metal particles and/or metal oxide particles is preferably 1 to 100 nm. In this case, a dry film having a storage elastic modulus specified in the present application tends to be more suitably formed. Moreover, good reducibility at 250°C or lower and good bonding strength tend to be ensured. The average thickness may also be preferably 5 to 90 nm, more preferably 10 to 50 nm, still more preferably 15 to 40 nm. Herein, the term "bonding strength" as used alone includes both temporary bonding strength and permanent bonding strength.

The D50 of the metal particles and/or metal oxide particles refers to a median diameter (median value) determined when each particle is regarded as a sphere. The D50 is preferably 100 to 350 nm. In this case, a dry film having a storage elastic modulus specified in the present application tends to be more suitably formed. Moreover, good bonding strength tends to be ensured. It has also been found that, as the particle size of the metal particles and/or metal oxide particles decreases, cracks or peeling at the bonding parts tends to occur due to thermal contraction. In order to facilitate the suppression of these defects, the D50 may be suitably 180 to 350 nm, more preferably 200 to 320 nm.

From another standpoint, the average value of the major axis (average major axis) of the metal particles and/or metal oxide particles may be, for example, 300 to 1000 nm, preferably 300 to 900 nm, more preferably 300 to 700 nm, still more preferably 400 to 700 nm. When the average major axis is within the above range, a dry film having a storage elastic modulus specified in the present application tends to be more suitably formed. The average major axis within the above range is also suitable from the standpoint of suppressing cracks or peeling at the bonding parts.

From another standpoint, when the metal particles and/or metal oxide particles are silver oxide particles, the silver oxide may suitably have an X-ray diffraction spectrum in which the full width at half maximum of the diffraction peak derived from the (111) plane of silver oxide is 0.80 or more, more preferably 0.85 or more. The upper limit is not limited and may be, for example, 1.20 or less, preferably 1.12 or less. Moreover, the (111) plane of silver oxide has a main peak at 32° to 33°. The full width at half maximum within the above range is suitable because the bonding strength then tends to improve as compared with when using spherical metal particles and/or metal oxide particles having a comparable D50. This is presumably because silver oxide with a full width at half maximum of 0.80 or more is considered to have low crystallinity, such that the binding force of Ag-O constituting the crystals is lowered, which permits reduction to occur readily at lower temperatures. The lowered crystallinity of the silver oxide is presumably due to a grinding process described later. When a raw material silver oxide is ground, the particle size decreases to a certain extent, but once the particle size reaches the minimum limit, the silver oxide presumably can no longer be broken and instead may undergo plastic deformation into a flake shape. Presumably, the crystallinity decreases due to the plastic deformation.

Moreover, from the standpoint of suppressing cracks or peeling at the bonding parts, suitably, the aspect ratio (l/t) of the average major axis (l) to the average thickness (t) is usually 8 to 20, preferably 14 to 18. The aspect ratio may be calculated from the average thickness and the average major axis of the metal particles and/or metal oxide particles.

When at least some of the metal particles and/or metal oxide particles in the paste contain, at the surface, a compound having a glycol ether skeleton in the main chain and/or side chain, the particles can be readily reduced at low temperatures, which is suitable. The expression "contain, at the surface" means that the compound is adhered to the surfaces of the metal particles and/or metal oxide particles, for example, by chemical bonding or physical adsorption.

Here, the particle shape identification, D50, average thickness, average major axis, and XRD full width at half maximum can be determined or measured by the measurement methods described in detail later.

The metal particles and/or metal oxide particles having a flake shape can be obtained, for example, by subjecting commercially available metal particles and/or metal oxide particles (for example, silver oxide particles generally having a spherical or substantially spherical shape with a particle size of about 1 to 20 µm) as a raw material to grinding using a bead milling device. Generally, silver oxide particles having a microparticle size or less are spherical particles obtained by precipitation from a silver salt solution, as disclosed in JP 2005-104825 A. In contrast, particles formed by grinding with a bead milling device have a flake shape. Here, the grinding with a bead milling device may be performed in a wet process. In this case, as the raw material used includes a grinding target and a dispersing medium, the particles obtained after grinding are in the slurry state (hereinafter, such particles may be referred to simply as "slurry").

The intended average thickness, D50 value, and average major axis of the metal particles and/or metal oxide particles can be controlled by appropriately adjusting the duration of grinding with a bead milling device, the rotor peripheral speed, the bead filling factor, or other conditions. The duration may be, for example, about 100 to 500 minutes, depending on the size of the desired flaky silver oxide powder. As the duration increases, grinding further proceeds, resulting in a tendency for the D50 value to decrease. Moreover, the rotor peripheral speed is suitably, for example, about 5 to 20 m/s, and the bead filling factor is suitably, for example, about 70 to 95 vol%.

Under such conditions, a person skilled in the art is able to set appropriate conditions by identifying the particle morphology of the metal particles and/or metal oxide particles. Moreover, depending on the size of the desired metal particles and/or metal oxide particles, the particles may be ground in two or more stages using beads differing in, for example, bead size or type to gradually reduce their size. In addition, a known cooling or temperature control mechanism may be provided to prevent the temperature in the bead milling device or grinding chamber from increasing excessively.

The percentage of the metal particles and/or metal oxide particles having a flake shape based on 100 mass% of the metal particles and/or metal oxide particles contained in the paste is preferably 60 mass% or more, more preferably 80 mass% or more, still more preferably 90 mass% or more, and may be 100 mass%.

The percentage of silver oxide particles based on 100 mass% of the metal particles and/or metal oxide particles contained in the paste is preferably 60 mass% or more, more preferably 80 mass% or more, still more preferably 90 mass% or more, and may be 100 mass%.

The percentage of flake-shaped silver oxide particles based on 100 mass% of the metal particles and/or metal oxide particles contained in the paste is preferably 60 mass% or more, more preferably 80 mass% or more, still more preferably 90 mass% or more, and may be 100 mass%.

Although the amount of the metal particles and/or metal oxide particles contained in the paste is not limited as long as the paste exhibits suitable coatability during the application, the amount is, for example, 70 to 95 mass%, preferably 75 to 85 mass% based on the total mass of the paste.

The paste preferably contains the metal particles and/or metal oxide particles, a compound having an ethylene-based or propylene-based glycol ether skeleton as a dispersing medium for keeping the metal particles and/or metal oxide particles in a dispersed state, and a compound having a glycol ether skeleton in the main chain and/or side chain as a dispersant for dispersing the metal particles and/or metal oxide particles.

The dispersing medium used in the paste is preferably a compound that exhibits coatability suitable for application, has an ethylene-based or propylene-based glycol ether skeleton, and is volatile during the processes upon bonding. Suitable examples include diethylene glycol methyl ether (methyl carbitol), triethylene glycol methyl ether (methoxy triglycol), diethylene glycol methyl ether (carbitol), triethylene glycol methyl ether (ethoxy glycol), ethylene glycol propyl ether (propyl cellosolve), ethylene glycol monobutyl ether (butyl cellosolve), diethylene glycol monobutyl ether (butyl carbitol), triethylene glycol n-butyl ether (butoxy triglycol), ethylene glycol hexyl ether (hexyl cellosolve), diethylene glycol hexyl ether (hexyl carbitol), ethylene glycol n-butyl ether acetate (butyl cellosolve acetate), diethylene glycol n-butyl ether acetate (butyl carbitol acetate), ethylene glycol phenyl ether (Eph), propylene glycol methyl ether, dipropylene glycol methyl ether, tripropylene glycol methyl ether, propylene glycol n-propyl ether, dipropylene glycol n-propyl ether, propylene glycol n-butyl ether, dipropylene glycol n-butyl ether, tripropylene glycol n-butyl ether, propylene glycol methyl ether acetate, dipropylene glycol methyl ether acetate, propylene glycol diacetate, and propylene glycol phenyl ether. Each of these may be used alone, or two or more of these may be used in combination. Diethylene glycol monobutyl ether is preferred among these.

The dispersing medium may be used in an amount of, for example, 8 to 30 mass%, preferably 10 to 25 mass%, more preferably 13 to 20 mass%, based on the total mass of the paste.

Here, when using two or more dispersing media, the amount means the total amount. The same applies to other similar descriptions.

The dispersant usable in the paste may suitably be a compound having a glycol ether skeleton in the main chain and/or side chain. Any of various dispersants may be used, which can keep the metal particles and/or metal oxide particles in a dispersed state in the dispersing medium. Examples of such dispersants include polymer compounds that have a main chain with a styrene, maleic acid, acrylic acid, methacrylic acid, or aminoethyl methacrylate, or other skeleton, and a side chain with a glycol ether polymer having a molecular weight of 100 or more. Each of these may be used alone, or two or more of these may be used in combination. The upper limit of the molecular weight of the dispersant may be, for example, 100000 or less. Moreover, the carboxyl group of the main chain maleic acid, acrylic acid, or methacrylic acid may form a salt with an amine compound to adjust the acid value or amine value. Suitable examples of such polymer compounds include products with the trade names BYK-190, BYK-194N, and BYK-2055 (all available from BYK).

The dispersant may be present in an amount of, for example, 12 mass% or less based on the total mass of the paste. It may preferably be used in an amount of 5 mass% or less, more preferably 4.5 mass% or less. Moreover, the lower limit of the amount is not limited as long as dispersion can be achieved. For example, the lower limit may be 0.5 mass% or more, preferably 1 mass% or more, more preferably 2 mass% or more. When the amount of the dispersant is 4.5 mass% or less based on the total mass of the paste, better bonding strength tends to be obtained.

In a suitable embodiment of the present disclosure, preferably, the paste contains silver oxide and further contains a protic additive instead of a known reducing agent for silver oxide. Although the presence of the protic additive facilitates the reduction reaction of silver oxide, the reduction reaction proceeds very slowly compared to when a reducing agent is used. Therefore, the paste may be dried by heating, and the dried applied layer (i.e., dry film) may then be used for bonding to a chip or the like. This can reduce the formation of voids in the bonding layer.

As described above, the paste preferably contains silver oxide particles as the metal particles and/or metal oxide particles and further contains a protic additive. This can allow the reduction reaction of silver oxide to further proceed, even without a reducing agent, thereby reducing the amount of unreduced silver oxide in the bonding layer. Even though the presence of some unreduced silver oxide in the bonding layer has no significant effect on bonding strength, it may adversely affect thermal conduction or electrical conductivity. Furthermore, since it is possible to dry the paste by heating, the dried applied layer (i.e., dry film) may be used for bonding to a chip or the like, which reduce the formation of voids in the bonding layer.

As described above, in the present disclosure, a compound having an ethylene-based or propylene-based glycol ether skeleton is preferably used as the dispersing medium used in the paste. When the dispersing medium (a compound having an ethylene-based or propylene-based glycol ether skeleton) is used together with the protic additive, the aldehyde generated from the glycol ether during the reaction process may be oxidized to release electrons, and therefore the reduction reaction of silver oxide tends to proceed at a more appropriate rate.

Any of various protic additives that can release a proton may be used as the protic additive. Examples of such protic additives include water, alcohols such as methanol and ethanol, and hydrogen peroxide water. Each of these may be used alone, or two or more of these may be used in combination. Water is preferred among these. The protic additive may be used in an amount of, for example, 0.5 to 10 mass%, preferably 1 to 7 mass%, more preferably 2 to 6 mass%, based on the total mass of the paste.

The paste may contain other optional components within a range that does not impair the various properties of the paste. For example, the use of a known plasticizer (e.g., polyethylene glycol (PEG), dibutyl phthalate, or butyl benzyl phthalate) with flake-shaped silver oxide particles having a D50 of less than 200 nm can further reduce cracks or peeling occurring during the reduction of silver oxide or during the drying of the paste.

In addition to the above, the paste may contain various fillers, known reducing agents, and other components within a range that does not impair the various properties of the paste. Each of these may be used alone, or two or more of these may be used in combination.

The combined amount of the metal particles and/or metal oxide particles, dispersants, and dispersing media is preferably 90 mass% or more, more preferably 95 mass% or more, based on the total mass of the paste. In this case, better bonding strength tends to be achieved even by bonding at low temperatures.

The combined amount of the metal particles and/or metal oxide particles, dispersants, dispersing media, and protic additives is preferably 90 mass% or more, more preferably 95 mass% or more, based on the total mass of the paste. In this case, better bonding strength tends to be achieved even by bonding at low temperatures, and also the reduction reaction of silver oxide tends to further proceed.

The paste can be obtained by mixing the components using a known apparatus for pastes or paint, such as a dispersing machine or a kneading device, under conditions sufficient not to cause further grinding. The paste can provide good bonding strength even upon bonding at low temperatures and is therefore suitable for temporary bonding.

### (Methods for measuring various properties)

### (1) Measurement of average major axis

The paste prepared as above is diluted by a factor of 1000 with butyl carbitol, and 1 ml of the resulting dilution is applied to a smooth glass substrate (20 mm × 20 mm) by spin coating (rotation speed: 2000 rpm) and then vacuum dried at room temperature to obtain a deposit of particles (e.g., flake-shaped silver oxide particles). Here, the flake-shaped silver oxide particles, when applied to a substrate such as a glass substrate, are deposited so that the flat parts of their flake shape are oriented upward and downward, respectively.

Next, the deposit is observed from above using a scanning electron microscope (SU-8220 available from Hitachi High-Tech Corporation) to measure the major axes of 20 randomly selected particles. An average value is calculated from the measured values and taken as the average major axis of the particles. Here, the longest diagonal of a particle observed from above is taken as the major axis of the particle.

### (2) Measurement of average thickness

One milliliter of the paste prepared as above is applied to a smooth glass substrate (20 mm × 20 mm) by screen printing and then vacuum dried at room temperature to obtain a deposit of particles (e.g., flake-shaped silver oxide particles). Next, the glass substrate is cut at a position where the formed deposit is present to give a sample that allows for observation from the cross-sectional direction of the particles (e.g., flake-shaped silver oxide particles). Subsequently, the thicknesses of 20 randomly selected particles in the cross-section of the deposit are measured using a scanning electron microscope (SU-8220 available from Hitachi High-Tech Corporation). An average value is calculated from the measured values and taken as the average thickness of the particles. Here, the distance between the upper and lower surfaces of the central part of each particle is taken as the thickness of the particle.

### (3) Measurement of D50

The term "D50 value" means the median diameter (median value) (based on the scattering intensity measured in a dynamic light scattering method) when individual particles are regarded as spheres, and it is a statistical value in which half of the total particles are present above the value and the remaining half are present below the value.

The D50 value is measured by diluting the paste prepared as above by a factor of 1000 with butyl carbitol and measuring the resulting dilution using a dynamic light scattering measurement device (Zetasizer Nano ZS available from Malvern Panalytical).

### (4) Powder X-ray diffraction (XRD) measurement

The slurry prepared as above is centrifuged (centrifugal force: 20000×g) to separate it into solids and a supernatant. After removing the supernatant, the resulting solids are vacuum dried at room temperature to obtain a dry powder.

The diffraction peaks of the dry powder are measured using a powder XRD measurement device (MINIFLEX 600 available from Rigaku Corporation), and the full width at half maximum is calculated from the measured diffraction peaks by fitting the data of the main peak (32°) of the (111) plane of the particles (e.g., flake-shaped silver oxide particles) using a pseudo-Voigt function.

### (5) Determination of dispersant

The slurry prepared as above is centrifuged (centrifugal force: 20000×g) to separate it into solids and a supernatant. After removing the supernatant, the solids are vacuum dried at room temperature to obtain a dry powder. The dry powder is analyzed with a differential thermogravimetric/differential thermal analyzer (TG-DTA; Thermoplus TG8120 available from Rigaku Corporation), and the amount of the dispersant used (adhered to particles) is calculated from the mass loss rate.

### <Dry film formation step>

The application step is followed by a dry film formation step which includes drying the paste containing a metal and/or a metal oxide formed on the component A to be bonded, to form a dry film having a storage elastic modulus of 15 GPa or less. More specifically, the dry film formation step includes drying the paste containing a metal and/or a metal oxide applied in the application step to form the dry film on the component A to be bonded.

The paste may preferably be dried at a temperature of 60°C to 145°C, more preferably 80°C to 130°C, still more preferably 90°C to 125°C.

Although the duration of drying may vary depending on the relationship with the drying temperature used, it is usually 10 minutes to one hour and may be in the range of 20 to 40 minutes.

The dry film formation step may be performed in the air or in an inert gas atmosphere. In order to simplify the process, the dry film formation step is preferably performed in the air.

Non-limiting examples of the inert gas include noble gas, such as argon gas, and nitrogen gas. Each of these may be used alone, or two or more of these may be used in combination. Nitrogen gas is preferred among these.

### (Dry film)

The paste is dried to form a dry film.

The dry film has a storage elastic modulus of 15 GPa or less, preferably 12 GPa or less, more preferably 10 GPa or less, still more preferably 7 GPa or less, particularly preferably 6 GPa or less. Since a lower storage elastic modulus of the dry film leads to stronger temporary bonding, the lower limit of the storage elastic modulus is not limited. From the standpoint of the production of a dry film, the lower limit may be 1.0 GPa or more, for example. In order to achieve stronger permanent bonding, the lower limit may be 4.0 GPa or more or 5.0 GPa or more. When the dry film has a storage elastic modulus that is 4.0 GPa or more and 12 GPa or less, preferably 5.0 GPa or more and 10 GPa or less, a better balance between temporary bonding strength and permanent bonding strength tends to be achieved.

Herein, the storage elastic modulus of the dry film is measured by a continuous stiffness measurement method (dynamic mechanical analysis), in which, according to a nanoindentation method, a nanoindenter is pressed into an object to be measured while a small sine wave is applied to the indenter, and in which the measurement temperature is 25°C, the indenter used is a triangular pyramidal diamond indenter, the maximum load (set value) to be reached during the load application process is 0.5 mN, and the strain rate during the load application process is 0.05/s.

When the paste is dried, the dispersing medium contained in the paste can evaporate, and voids can accordingly be created in the formed dry film. The presence of such voids reduces the storage elastic modulus of the dry film. Therefore, the drying conditions are very important to form a dry film having a storage elastic modulus of 15 GPa or less. A lower drying temperature tends to lead to a lower storage elastic modulus of the dry film.

The dry film preferably contains silver oxide particles and/or silver particles, more preferably silver oxide particles. Such a dry film tends to provide better temporary bonding strength.

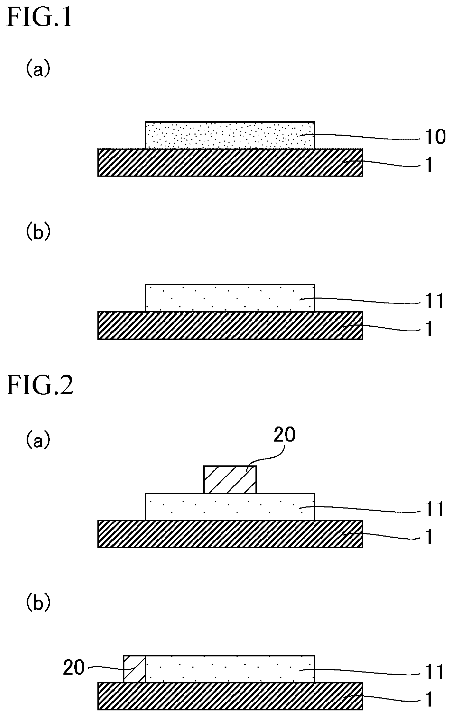

With reference to FIG. 1, an example of a paste containing a metal and/or a metal oxide formed on a component A to be bonded, and an example of a dry film formed on the component A to be bonded are now described. FIG. 1 describes examples in which the component A to be bonded is a substrate.

FIG. 1 (a) is a schematic diagram schematically showing an example of a paste containing a metal and/or a metal oxide formed on a component A to be bonded. FIG. 1 (b) is a schematic diagram schematically showing an example of a dry film formed on the component A to be bonded.

In FIG. 1 (a), a paste 10 (a paste containing a metal and/or a metal oxide) is formed on the main surface of a substrate 1. The substrate 1 with the paste 10 formed thereon is dried so that the paste 10 is dried to form a dry film having a storage elastic modulus of 15 GPa or less. In FIG. 1 (b), the dry film 11 (a dry film having a storage elastic modulus of 15 GPa or less) is formed on the main surface of the substrate 1.

Herein, the term "main surface" refers to the surface having the largest area among the surfaces of the component.

### <Step of placing component B to be bonded>

The dry film formation step is followed by a step of placing a component B to be bonded. This step includes placing a component B to be bonded that is in contact with the dry film formed in the dry film formation step.

The component B to be bonded may be placed at any position where it can contact the dry film. Thus, the dry film may be provided at a desired position where it is desired to place the component B to be bonded, and the component B to be bonded may then be placed at the position.

For example, the component B to be bonded may be placed on a surface of the dry film formed on the component A to be bonded, the surface being on a side opposite to the component A to be bonded. Or, the component B to be bonded may be placed on a surface of the dry film formed on the component A to be bonded, the surface being perpendicular to the component A to be bonded.

The placement of a semiconductor chip may be performed using a known apparatus, such as a flip-chip bonder, a die bonder, or a chip mounter. Each of these may be used alone, or two or more of these may be used in combination.

With reference to FIG. 2, the placement of the component B to be bonded is now illustrated as an example. FIG. 2 shows an example in which the component A to be bonded is a substrate, and the component B to be bonded is a semiconductor chip. In FIG. 2 (a), a semiconductor chip 20 is placed on a surface of a dry film 11 formed on a substrate 1, the surface being on a side opposite to the substrate 1.

In contrast, in FIG. 2 (b), the semiconductor chip 20 is placed on a surface of the dry film 11 formed on the substrate 1, the surface being perpendicular to the substrate 1.

### <Temporary bonding step>

The step of placing a component B to be bonded is followed by a temporary bonding step which includes temporarily bonding the component B to be bonded to the component A to be bonded via the dry film formed in the dry film formation step.

Through the step of placing a component B to be bonded, the component B to be bonded is placed that is in contact with the dry film formed on the component A to be bonded in the dry film formation step. Thus, when temporary bonding proceeds under these conditions, the component B to be bonded will be temporarily bonded to the component A to be bonded via the dry film formed in the dry film formation step.

The temporary bonding step preferably includes heating, preferably pressing and heating, the component B to be bonded that is in contact with the dry film formed on the component A to be bonded, thereby temporarily bonding the component B to be bonded to the component A to be bonded via the dry film. More preferably, the temporary bonding step includes placing the component B to be bonded on a surface of the dry film formed on the component A to be bonded, the surface being on a side opposite to the component A to be bonded, followed by temporarily bonding the component B to be bonded to the component A to be bonded via the dry film by heating, preferably by pressing and heating. The heating causes partial sintering, thereby fixing the component B to be bonded to the component A to be bonded via the dry film.

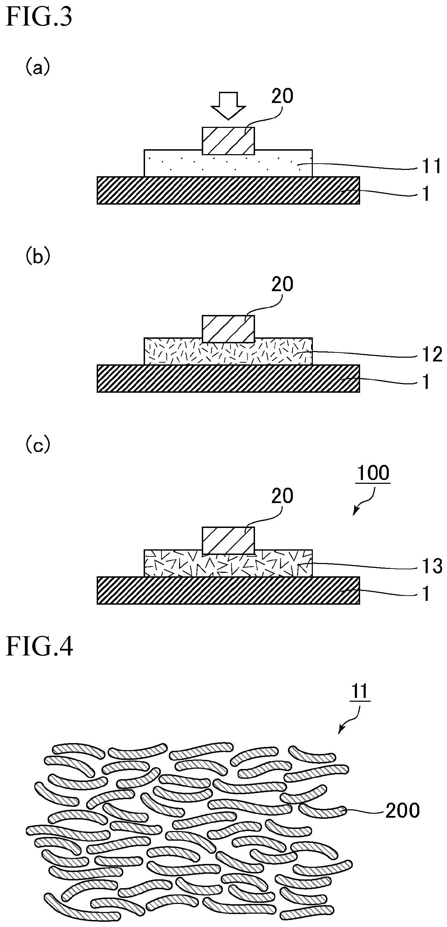

When pressing is performed in the temporary bonding step, the component B to be bonded is pressed against the dry film. With reference to FIG. 3 (a), an exemplary behavior during pressing in the case shown in FIG. 2 (a) is now described.

FIG. 3 (a) is a schematic diagram schematically showing an exemplary behavior during pressing in a temporary bonding step.

In FIG. 3 (a), a semiconductor chip 20 is placed on a surface of a dry film 11 formed on a substrate 1, the surface being on a side opposite to the substrate 1, and pressing is further performed so that the semiconductor chip 20 is pressed against the dry film 11. Note that FIG. 3 (a) is a schematic diagram which does not accurately reflect the dimensions and other conditions, and that, in FIG. 3 (a), the semiconductor chip 20 is embedded into the dry film 11 to clearly illustrate the pressed state; however, it is not usually embedded to such a great extent. The same applies to FIG. 3 (b) and FIG. 3 (c).

FIG. 3 (b) is a schematic diagram schematically showing an example of a component to be bonded after a temporary bonding step. After a temporary bonding step is performed under the conditions shown in FIG. 3(a), the conditions are changed to those shown in FIG. 3 (b).

In FIG. 3 (b), a dry film 11 formed on a substrate 1 is converted to a temporarily bonded dry film 12 by a temporary bonding step. Then, a semiconductor chip 20 is temporarily bonded to a surface of the temporarily bonded dry film 12 formed on the substrate 1, the surface being on a side opposite to the substrate 1.

With regard to the temperature in the temporary bonding step, the temperature of the component A to be bonded (substrate) is preferably 80°C to 150°C, more preferably 90°C to 150°C, still more preferably 100°C to 150°C, and the temperature of the component B to be bonded (semiconductor chip) is preferably 100°C to 260°C, more preferably 100°C to 210°C, still more preferably 150°C to 210°C, particularly preferably 170°C to 210°C.

In general, a copper or copper material-composite substrate is often used as the component A to be bonded (substrate). From the standpoint of preventing copper oxidation, the temperature of the component A to be bonded (substrate) is preferably set to be lower than the temperature of the component B to be bonded (semiconductor chip).

The pressure in the temporary bonding step is preferably 0.1 to 5 MPa, more preferably 1 to 3.5 MPa, still more preferably 1.5 to 3.5 MPa. The process duration (duration of pressing and heating) during the temporary bonding step is preferably 0.1 to 5 seconds, more preferably 0.5 to 4 seconds.

Herein, the pressure refers to the pressure applied to a component provided on the main surface of a component A to be bonded in a direction perpendicular to the main surface of the component A to be bonded.

The temporary bonding step may be performed either in the air or in an inert gas atmosphere. In order to simplify the process, the temporary bonding step is preferably performed in the air.

The temporary bonding step may be performed using a known apparatus. Examples of usable apparatus include apparatus that can control the temperature of the component A to be bonded and the temperature of the component B to be bonded individually. In the case where the known apparatus, such as a flip-chip bonder, a die bonder, or a chip mounter, used in the step of placing a component B to be bonded has a heating mechanism, preferably together with a pressing mechanism, heating and, preferably, pressing may be performed directly, which can further reduce misalignment. Each of these apparatuses may be used alone, or two or more of these may be used in combination.

The temporary bonding strength between the component A to be bonded and the component B to be bonded after the temporary bonding step is preferably 0.5 N or more, more preferably 0.8 N or more, still more preferably 1.0 N or more. Although the upper limit is not limited, it is, for example, 50 N or less.

Herein, the temporary bonding strength is measured by the method described in EXAMPLES.

### <Permanent bonding step>

The temporary bonding step is followed by a permanent bonding step. Usually, a preparation step is performed after the temporary bonding step but before the permanent bonding step. The preparation step includes, for example, transporting the substrate with the semiconductor chip temporarily bonded thereto; removing parts of the dry film not in contact with the component B to be bonded (the unnecessary dry film, such as the portions on both sides of the dry film 11 on which the semiconductor chip 20 is not placed in FIG. 2 (a)); or covering with a protection sheet. As described above, misalignment of the semiconductor chip is likely to occur in the preparation step.

Moreover, in the permanent bonding step, misalignment of the semiconductor chip may occur when pressing the semiconductor chip via a protection sheet or the like. If the method for producing a semiconductor device is likely to cause misalignment of the semiconductor chip as described above, a semiconductor device with the semiconductor chip in misalignment is likely to be formed by the immediately subsequent permanent bonding, leading to a decrease in production yield.

In contrast, in the present disclosure, as the component B to be bonded is temporarily bonded to the component A to be bonded via the dry film having a storage elastic modulus of 15 GPa or less, the component B to be bonded can be relatively firmly fixed to the component A to be bonded via the dry film even in temporary bonding. Thus, it is possible to reduce misalignment of a component to be bonded, such as a semiconductor chip.

The temporary bonding step and optionally other subsequent steps are followed by a permanent bonding step which includes permanently bonding the component B to be bonded to the component A to be bonded by heating. This causes sintering and grain growth, so that the component A to be bonded, the component B to be bonded, and the particles can be firmly sintered together. Thus, the component B to be bonded is permanently bonded to the component A to be bonded.

In the permanent bonding step, heating may be performed with or without pressing.

When heating is performed with pressing, for example, a heating apparatus may be used which is equipped with a pressing mechanism capable of pressing so that the component A to be bonded and the component B to be bonded are brought close to each other in the thickness direction of the dry film, such as any sintering apparatus. In this case, the apparatus may be either a single-wafer processing apparatus that can process one substrate at a time, or a batch processing apparatus that can process multiple substrates at a time. In order to improve processing efficiency, a batch processing apparatus is preferably used.

Moreover, without pressing, it is not necessary to include a pressing mechanism and, therefore, a known heating apparatus, such as any reflow furnace, a hot plate, or a box furnace, may be used.

Here, the expression "heating is performed with pressing" means that it is sufficient that heat and pressure be applied simultaneously to a component to be bonded at any one time during the process, and that heating and pressing may start or end at the same time or at different times.

When heating is performed with pressing in the permanent bonding step, a shorter duration of heating tends to be ensured than when heating is performed without pressing. In other words, the permanent bonding step preferably includes permanently bonding the component B to be bonded to the component A to be bonded by pressing and heating after temporarily bonding the component B to be bonded to the component A to be bonded in the temporary bonding step.

The pressing in the permanent bonding step allows the component B to be bonded to be pressed against the dry film. The behavior during the pressing is as described for the temporary bonding step.

FIG. 3 (c) is a schematic diagram schematically showing an example of a component to be bonded after a permanent bonding step. After a permanent bonding step is performed under the conditions shown in FIG. 3 (b), the conditions are changed to those shown in FIG. 3 (c).

In FIG. 3 (c), a temporarily bonded dry film 12 formed on a substrate 1 is converted to a permanently bonded dry film 13 by a permanent bonding step. Then, a semiconductor chip 20 is permanently bonded to a surface of the permanently bonded dry film 13 formed on the substrate 1, the surface being on a side opposite to the substrate 1. Thus, a semiconductor device 100 can be produced in which the semiconductor chip 20 is placed on the main surface of the substrate 1 via the permanently bonded dry film 13. Accordingly, a semiconductor device in which a component B to be bonded is placed on a component A to be bonded via a dry film can be produced.

The temperatures of both the component A to be bonded (substrate) and the component B to be bonded (semiconductor chip) during the permanent bonding step are preferably 230°C to 300°C, more preferably 240°C to 300°C, still more preferably 245°C to 300°C.

When pressing and heating are performed in the permanent bonding step, the pressure in the permanent bonding step is preferably 5 to 20 MPa, more preferably 7 to 20 MPa, still more preferably 8 to 20 MPa.

Although the process duration (duration of pressing and heating) during the permanent bonding step is not limited as long as bonding can be achieved at the above-described pressure and temperature, the duration is preferably 1 to 10 minutes, more preferably 1.5 to 5 minutes.

In the permanent bonding step without pressing, the heating temperature may be as described above. Although the process duration (duration of heating) during the permanent bonding step is not limited as long as bonding can be achieved at the above-described temperature, the duration is preferably 15 to 60 minutes, more preferably 30 to 60 minutes. Depending on the thinness or warpage of the substrate, or the shape of each component to be bonded or the dry film, for example, damage may be likely to occur during pressing in the permanent bonding step, or strong pressure may be difficult to apply. In contrast, the permanent bonding step without pressing enables bonding of a wider variety of substrates, components to be bonded, or the like.

Herein, the term "without pressing" means that no intentional operation is made to apply pressure so that the component A to be bonded and the component B to be bonded are brought close to each other in the thickness direction of the dry film. However, the conditions "without pressing" include cases in which a fixing jig is attached.

It suffices that the temporary bonding step is performed under conditions that allow sintering to partially proceed, as will be described later. On the other hand, it suffices that the permanent bonding step is performed under conditions that allow sintering and grain growth to proceed, as will be described later. Therefore, the permanent bonding step performed after the temporary bonding step is usually carried out at a higher temperature than the temporary bonding step. Moreover, the permanent bonding step may be carried out at a higher pressure than the temporary bonding step. Under such conditions, both temporary bonding strength and permanent bonding strength tend to be more suitably achieved. Thus, the temperature in the permanent bonding step is preferably higher than the temperature in the temporary bonding step. For the same reason, the pressure in the permanent bonding step may be higher than the pressure in the temporary bonding step.

The permanent bonding step may be performed either in the air or in an inert gas atmosphere. When the substrate used is a metal, the permanent bonding step is preferably performed in an inert gas atmosphere to prevent oxidation. The inert gas is preferably nitrogen gas.

The permanent bonding strength between the component A to be bonded and the component B to be bonded after the permanent bonding step is preferably 20 MPa or more, more preferably 25 MPa or more. Although the upper limit is not limited, it is, for example, 100 MPa or less.

Herein, the permanent bonding strength is measured by the method described in EXAMPLES.

An example of a method for producing a semiconductor device of the present disclosure is described above. However, the method may include steps other than the above steps as long as they do not impair the advantageous effect of the present disclosure. For example, the method may include determining the presence or absence of misalignment of the component B to be bonded at at least one of the following timings: "after the temporary bonding step but before the preparation step", "after the preparation step but before the permanent bonding step", and "after the permanent bonding step". Moreover, the method may include positioning a component B to be bonded before the step of placing a component B to be bonded. Moreover, although the description with reference to drawings is about a case where the component A to be bonded is a substrate and the component B to be bonded is a semiconductor chip, the component A to be bonded may be a semiconductor chip and the component B to be bonded may be a substrate, or the combination of the component A to be bonded and the component B to be bonded may be a combination of components of the same type and therefore is not limited.

In the present disclosure, preferably, no tackifier is used in the temporary bonding step. According to the present disclosure, the temporary bonding of the component B to be bonded to the component A to be bonded allows the component B to be bonded to be temporarily fixed to the component A to be bonded. Thus, the component B to be bonded can be temporarily fixed to the component A to be bonded without using a tackifier. If a tackifier is used, the organic components in the tackifier may remain during permanent bonding, resulting in voids. Moreover, the tackifier may creep up to the chip edge during pressing, causing insulation failure. Further, it is necessary to include an additional step of applying (dispensing) a tackifier. In contrast, the present disclosure does not need to use a tackifier and thus can solve the above problems.

A bonding sheet containing a large amount of an organic binder may be used to utilize the flexibility and adhesion of the organic binder during the temporary fixing. However, also in this case, the presence of such a large amount of an organic binder may result in voids left during bonding or chip contamination. In contrast, the present disclosure does not need to use an organic binder during the temporary bonding step and thus can solve the above problems.

Next, the phenomena or the like occurred during the dry film formation step, the temporary bonding step, and the permanent bonding step will be described. In the following description, a surface of a dry film refers to a surface of the dry film on a side opposite to a component A to be bonded on which the dry film is formed. Moreover, a cross-section of a dry film refers to a cross-section of the dry film cut in parallel with the width direction (the horizontal direction in FIG. 1 (b)) of the dry film and also in a direction perpendicular to the main surface of a component A to be bonded on which the dry film is formed.

As described above, the dry film formation step includes drying a paste containing a metal and/or a metal oxide to form a dry film. When the paste containing a metal and/or a metal oxide is dried, the dispersing medium contained in the paste can evaporate, and voids can accordingly be created in the formed dry film. The presence of such voids reduces the storage elastic modulus of the dry film.

FIG. 4 is a schematic diagram schematically showing an example of a cross-section of a dry film.

In FIG. 4, a dry film 11 is formed in which flake-shaped particles 200 overlap with each other while containing voids. When such a paste containing flake-shaped particles is applied and dried, a dry film can be obtained in which the flake faces are oriented upward and downward, respectively. When a dry film is formed with flake-shaped particles, the storage elastic modulus of the dry film may be further reduced due to the presence of voids as well as the flexibility of the flake-shaped particles.

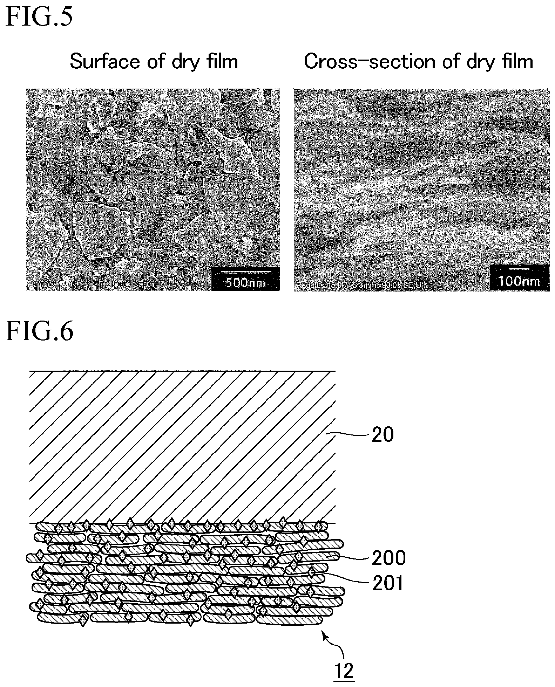

FIG. 5 shows drawing-substituting photographs of a surface and a cross-section of a dry film when using flake-shaped silver oxide particles.

As shown in FIG. 5, the dry film is such that the flake faces are oriented upward and downward, respectively.

Next, the temporary bonding step includes temporarily bonding a component B to be bonded to a component A to be bonded via the dry film formed in the dry film formation step. Usually, pressing and heating are performed in this step. When pressed, the dry film according to the present disclosure having a specified storage elastic modulus can readily conform to the surface shapes of the components A and B to be bonded, increasing the contact areas with the components A and B to be bonded and resulting in wide-range, overall surface contact between the dry film and the surfaces of the components A and B to be bonded, with improved adhesion. Further, voids can be collapsed by pressing, resulting in enhanced overall surface contact and further improved adhesion. Moreover, when a dry film is formed with flake-shaped particles, enhanced overall surface contact and further improved adhesion can be obtained by deformation of the flake-shaped particles, in addition to the above.

Then, heating causes partial sintering, thereby fixing the component B to be bonded to the component A to be bonded via the dry film.

FIG. 6 is a schematic diagram schematically showing an example of a cross-section of a temporarily bonded dry film when using flake-shaped silver oxide particles.

As shown in FIG. 6, pressing and heating cause partial reduction of silver oxide, so that nano Ag 201, which is a silver particle, is precipitated. Sintering of the nano Ag 201 allows a semiconductor chip 20 to be temporarily bonded (fixed) to a component A to be bonded (not shown, for example, a substrate) via a temporarily bonded dry film 12.

Next, the permanent bonding step includes permanently bonding the component B to be bonded to the component A to be bonded by heating after temporarily bonding the component B to be bonded to the component A to be bonded in the temporary bonding step. Usually, pressing and heating are performed in this step. This causes sintering and grain growth, so that the component A to be bonded, the component B to be bonded, and the particles can be firmly sintered together. Thus, the component B to be bonded is permanently bonded to the component A to be bonded.

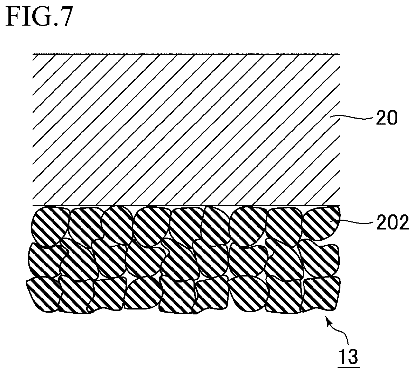

FIG. 7 is a schematic diagram schematically showing an example of a cross-section of a permanently bonded dry film when using flake-shaped silver oxide particles.

As shown in FIG. 7, pressing and heating cause reduction of silver oxide, resulting in nano Ag precipitation, and also cause sintering and grain growth, so that sintered and grain-grown Ag 202 is formed, and therefore a component A to be bonded (not shown, for example, a substrate), a component B to be bonded (a semiconductor chip 20), and sintered and grain-grown Ag 202 can be firmly sintered together. Thus, the component B to be bonded is permanently bonded (firmly fixed) to the component A to be bonded.

Here, when subjected to the dry film formation step and the temporary bonding step according to the present disclosure, the permanent bonding step without pressing can cause sintering and grain growth, so that the component B to be bonded is permanently bonded to the component A to be bonded.

Next, a method for distinguishing between the dry film before temporary bonding, the temporarily bonded dry film, and the permanently bonded dry film (i.e., sintered film) will be described.

When the dry film before temporary bonding and the temporarily bonded dry film are lightly scratched with something, their particle-accumulated structure can collapse so that the particles are separated from each other. In contrast, the particles in the permanently bonded dry film are firmly bonded and cannot be separated from each other. Here, the expression "particles are separated from each other" means that the particles are flowable (movable).

Thus, when a film is tested by, for example, the method stipulated in JIS K 5600-5-6:1999 "Testing methods for paints - Section 6: Adhesion test (Cross-cut test)", it corresponds to a permanently bonded dry film if the particles are not separated from each other. On the other hand, when a film is tested by the method, it corresponds to a dry film before temporary bonding or a temporarily bonded dry film if the particles are separated from each other. Then, among the dry film before temporary bonding and the temporarily bonded dry film, the film corresponds to the temporarily bonded dry film if partial sintering has proceeded so that the film is bonded to a component to be bonded, while it corresponds to the dry film before temporary bonding if it is not bonded to a component to be bonded (for example, sintering has not proceeded at all, or partial sintering has proceeded but the film is not bonded to a component to be bonded). Whether sintering has proceeded in the film and whether the film is bonded to a component to be bonded can be determined by direct observation with a scanning electron microscope.

### EXAMPLES

The present disclosure is described in detail below with reference to examples and comparative examples, though the scope of the present disclosure is not limited at all to the examples and comparative examples. Moreover, the following measured values were obtained using the measurement methods described above.

### (Production Example 1)

### - Preparation of flake-shaped silver oxide particles

The raw material silver oxide particles used as a raw material were micro silver oxide (Silver Oxide PS available from DOWA Electronics, spherical shape, particle size: 10 µm). The raw material silver oxide particles and water (dispersing medium) were mixed at a ratio of raw material silver oxide to water = 10:90 (mass ratio), and a dispersant (DISPER BYK-190 available from BYK, a compound having a glycol ether skeleton in the main chain and/or side chain) was further added in an amount of 20 mass% relative to the raw material silver oxide. The mixture was introduced into the grinding chamber of a bead milling device (Ultra Apex Mill UAM-015 available from Hiroshima Metal & Machinery Co., Ltd.) and then ground to obtain a slurry containing flake-shaped silver oxide particles. The beads used in the grinding process were zirconia (material) spheres with a diameter of 0.1 mm. The duration of grinding was 300 minutes.

### - Preparation of silver oxide paste

The resulting slurry containing flake-shaped silver oxide particles was centrifuged (centrifugal force: 20000×g) to separate it into solids and a supernatant, and the supernatant was removed to eliminate excess dispersant and water. Then, butyl carbitol as a dispersing medium was supplied to the resulting solids to disperse the solids again. The dispersion was then centrifuged (centrifugal force: 20000×g) to separate it into solids and a supernatant, and the supernatant was removed, thereby replacing the water in the dispersion with butyl carbitol.

Butyl carbitol and the dispersant were incorporated into the resulting solids to give the composition shown in Table 1 below. The mixture was stirred using a planetary centrifugal mixer having no grinding function, and then dispersed using a three-roll mill to prepare a silver oxide paste containing flake-shaped silver oxide particles. Here, the water content of the silver oxide paste was measured by gas chromatography, and the water content of the silver oxide paste was 3 mass%.

Table 1 shows the shape and characteristics of the flake-shaped silver oxide particles, and the composition of the paste.

**[Table 1]**

| Flake-shaped silver oxide particles | | | | | Composition of paste | | | | | | | | |
|---|---|---|---|---|---|---|---|---|---|---|---|---|---|
| Average major axis (nm) | Average thickness (nm) | Aspect ratio | D50 (nm) | Full width at half maximum | Amount of flake-shaped silver oxide particles (mass%) | Dispersant | | Dispersing medium | | Protic additive | | Others | |
| | | | | | | Component or trade name | Amount (mass%) | Component | Amount (mass%) | Component | Amount (mass%) | Component | Amount (mass%) |
| 591 | 33 | 18 | 233 | 0.97 | 79 | BYK-190 | 4 | Diethylene glycol monobutyl ether | 14 | Water | 3 | None | 0 |

### (Production Example 2)

Although, in Production Example 1, butyl carbitol and the dispersant were incorporated into the solids to give the composition shown in Table 1, and the mixture was stirred using a planetary centrifugal mixer having no grinding function and then dispersed using a three-roll mill to prepare a silver oxide paste containing flake-shaped silver oxide particles, nano Ag (spherical shape, D50: 130 nm) was used instead of the solids to prepare a nano Ag paste as in Production Example 1.

### (Examples and Comparative Examples)

The paste obtained above was used in the following experiments.

The obtained paste was applied to the main surface of a prepared substrate (Cu substrate with Ni-Ag plating applied on its surface) by screen printing. Next, the paste was dried under the conditions (in the air) indicated in Table 2 to form a dry film on the main surface of the substrate. Table 2 shows the storage elastic modulus of the dry film.

Next, using a die bonder, a semiconductor chip (Si chip, uppermost surface: Ag-sputtered film, surface size: 4 × 4 mm, thickness: 625 µm) was placed on a surface of the dry film formed on the main surface of the substrate, the surface being on a side opposite to the substrate, such that the Ag-sputtered film of the semiconductor chip came into contact with the surface. Here, a plurality of semiconductor chips were used for the substrate to measure the temporary bonding strength and the permanent bonding strength in the experiments.

Then, the substrate with the semiconductor chip placed thereon was pressed and heated under the conditions (in the air) indicated in Table 2, whereby the semiconductor chip was temporarily bonded to the substrate via the dry film. In Table 2, the temperature of the upper heater corresponds to the temperature of the semiconductor chip, and the temperature of the lower heater corresponds to the temperature of the substrate. Moreover, the pressure (applied pressure) in Table 2 refers to the pressure applied to the component (here, the semiconductor chip) provided on the main surface of the substrate in a direction perpendicular to the main surface of the substrate. Further, the substrate with the semiconductor chip temporarily bonded thereto was used to measure the temporary bonding strength by the method described below.

Next, using the substrate with the semiconductor chip temporarily bonded thereto, the semiconductor chip was permanently bonded to the substrate in a nitrogen gas atmosphere under any one of the conditions 1 to 3 below. Also, the substrate with the semiconductor chip permanently bonded thereto was used to measure the permanent bonding strength by the method described below. Here, the conditions used in the examples and comparative examples are indicated in Table 2.
(Condition 1) Using a sintering device capable of simultaneous heating and pressing, heating and pressing were performed for 120 seconds at upper heater and lower heater temperatures of 250°C and an applied pressure of 10 MPa.
(Condition 2) The substrate with the semiconductor chip temporarily bonded thereto was placed in a BOX-type dryer, and the temperature was raised from room temperature to 250°C over 60 minutes and then maintained at 250°C for 30 minutes (condition without pressing).
(Condition 3) The substrate with the semiconductor chip temporarily bonded thereto was placed on a hot plate set at 250°C such that the substrate was located on the hot plate side, and then heated for 30 minutes (condition without pressing).

### (Evaluation of chip misalignment after permanent bonding)

The substrate with the semiconductor chip temporarily bonded thereto was used to measure the distance from the end of the dry film to the end of the chip using a digital microscope VHX-500 available from Keyence Corporation.

Then, the substrate obtained by permanently bonding the same sample was used to measure the distance from the end of the permanently bonded dry film (sintered film) to the end of the chip in the same manner as described above. The sample was evaluated as "with chip misalignment" when a difference between the distances from the end of the dry film to the end of the chip measured before and after the permanent bonding was 0.5 mm or more, or as "without chip misalignment" when the difference was zero or less than 0.5 mm.

Moreover, the chip misalignment was evaluated using eight semiconductor chips.

### (Measurements of temporary bonding strength and permanent bonding strength)

The substrate with the semiconductor chip temporarily bonded thereto and the substrate with the semiconductor chip permanently bonded thereto were used to measure the bonding strength.

Specifically, the bonding strengths (temporary bonding strength and permanent bonding strength) of the obtained substrates were determined using a bond tester (DAGE 4000 Plus available from Dage Japan) by a die shear test (shear, conditions for temporarily bonded sample: load cell S50KG; measurement range 5 kgf; and shear speed 10 µm/s, and conditions for permanently bonded sample: load cell S200KG; measurement range 200 kgf; and shear speed 100 µm/s). Table 2 shows the results.

**[Table 2]**

| | Paste | Particle composition in paste | Particle shape in paste | D50 (nm) | Drying conditions | Storage elastic modulus of dry film [Gpa] | Temporary bonding conditions Upper heater/Lower heater, Duration, Applied pressure | Chip misaligned after permanent bonding [Number] | Temporary bonding strength [N] | Permanent bonding conditions | Permanent bonding strength [MPa] |
|---|---|---|---|---|---|---|---|---|---|---|---|
| Example 1 | Production Example 1 | Ag₂O | Flake | 233 | 80°C, 30 minutes | 2.7 | 200/100°C, 3 seconds, 3 MPa | 0/8 | 10.9 | 1 | 26 |
| Example 2 | Production Example 1 | Ag₂O | Flake | 233 | 100°C, 30 minutes | 6.7 | 200/100°C, 3 seconds, 3 MPa | 0/8 | 3.2 | 1 | 74 |
| Example 3 | Production Example 1 | Ag₂O | Flake | 233 | 120°C, 30 minutes | 9.5 | 200/100°C, 3 seconds, 3 MPa | 0/8 | 1.2 | 1 | 76 |
| Example 4 | Production Example 1 | Ag₂O | Flake | 233 | 100°C, 30 minutes | 6.7 | 200/100°C, 3 seconds, 3 MPa | 0/8 | 3.2 | 2 | 54 |
| Example 5 | Production Example 1 | Ag₂O | Flake | 233 | 80°C, 30 minutes | 2.7 | 250/80°C, 1 second, 2 MPa | 0/8 | 12.5 | 3 | 64 |
| Comparative Example 1 | Production Example 1 | Ag₂O | Flake | 233 | 150°C, 30 minutes | 19.0 | 200/100°C, 3 seconds, 3 MPa | 3/8 | 0.4 | 1 | 63 |
| Comparative Example 2 | Production Example 1 | Ag₂O | Flake | 233 | 200°C, 30 minutes | 24.6 | 200/100°C, 3 seconds, 3 MPa | 5/8 | 0.4 | 1 | 25 |
| Comparative Example 3 | Production Example 2 | Nano Ag | Sphere | 130 | 100°C, 30 minutes | 23.2 | 200/100°C, 3 seconds, 3 MPa | 4/8 | 0.4 | 1 | 43 |
| Comparative Example 4 | Production Example 2 | Nano Ag | Sphere | 130 | 100°C, 30 minutes | 23.2 | 200/100°C, 3 seconds, 3 MPa | 4/8 | 0.4 | 2 | 1 |
| Comparative Example 5 | Production Example 2 | Nano Ag | Sphere | 130 | 80°C, 30 minutes | 21.5 | 250/80°C, 3 seconds, 2 MPa | 3/8 | 0.6 | 3 | 2 |

As seen from Table 2, the temporary bonding strength was high and misalignment of a component to be bonded, such as a semiconductor chip, could be reduced in the examples including: a dry film formation step including drying a paste containing a metal and/or a metal oxide formed on a component A to be bonded, to form a dry film having a storage elastic modulus of 15 GPa or less; and a temporary bonding step including temporarily bonding a component B to be bonded to the component A to be bonded via the dry film formed in the dry film formation step.

It was also found that, in these examples, the temporary bonding strength was high and misalignment of a component to be bonded, such as a semiconductor chip, could be reduced, regardless of whether pressing was performed or not during the permanent bonding.

The present application claims priority under the Paris Convention and the law of the designated state to Japanese Patent Application No. 2023-176786 filed on October 12, 2023, the entire contents of which are hereby incorporated by reference.

### REFERENCE SIGNS LIST

1 substrate (component A to be bonded)
10 paste
11 dry film
12 temporarily bonded dry film
13 permanently bonded dry film
20 semiconductor chip (component B to be bonded)
100 semiconductor device
200 flake-shaped particle
201 nano Ag
202 sintered and grain-grown Ag

## Claims

1. A method for producing a semiconductor device, comprising:
a dry film formation step including drying a paste containing at least one of a metal or a metal oxide formed on a component A to be bonded, to form a dry film having a storage elastic modulus of 15 GPa or less; and
a temporary bonding step including temporarily bonding a component B to be bonded to the component A to be bonded via the dry film formed in the dry film formation step.

2. The method for producing a semiconductor device according to claim 1,
wherein the dry film formation step includes drying the paste containing at least one of a metal or a metal oxide formed on the component A to be bonded, to form the dry film having a storage elastic modulus that is 4.0 GPa or more and 12 GPa or less.

3. The method for producing a semiconductor device according to claim 1,
wherein the dry film formation step includes drying the paste containing at least one of a metal or a metal oxide formed on the component A to be bonded, to form the dry film having a storage elastic modulus that is 5.0 GPa or more and 10 GPa or less.

4. The method for producing a semiconductor device according to claim 1 or 2,
wherein the temporary bonding step includes heating the component B to be bonded that is in contact with the dry film formed on the component A to be bonded in the dry film formation step, thereby temporarily bonding the component B to be bonded to the component A to be bonded via the dry film.

5. The method for producing a semiconductor device according to claim 1 or 2,
wherein the temporary bonding step includes pressing and heating the component B to be bonded that is in contact with the dry film formed on the component A to be bonded in the dry film formation step, thereby temporarily bonding the component B to be bonded to the component A to be bonded via the dry film.

6. The method for producing a semiconductor device according to claim 1 or 2,
wherein the temporary bonding step includes placing the component B to be bonded on a surface of the dry film formed on the component A to be bonded in the dry film formation step, the surface being on a side opposite to the component A to be bonded, followed by temporarily bonding the component B to be bonded to the component A to be bonded via the dry film by heating.

7. The method for producing a semiconductor device according to claim 1 or 2,
wherein the temporary bonding step includes placing the component B to be bonded on a surface of the dry film formed on the component A to be bonded in the dry film formation step, the surface being on a side opposite to the component A to be bonded, followed by temporarily bonding the component B to be bonded to the component A to be bonded via the dry film by pressing and heating.

8. The method for producing a semiconductor device according to claim 1 or 2,
wherein the dry film contains silver oxide particles, silver particles, or both.

9. The method for producing a semiconductor device according to claim 1 or 2,
wherein the dry film contains silver oxide particles.

10. The method for producing a semiconductor device according to claim 1 or 2, further comprising a permanent bonding step including permanently bonding the component B to be bonded to the component A to be bonded by heating after temporarily bonding the component B to be bonded to the component A to be bonded in the temporary bonding step.

11. The method for producing a semiconductor device according to claim 10,
wherein the temporary bonding step includes temporarily bonding the component B to be bonded to the component A to be bonded via the dry film by heating, and
a temperature in the permanent bonding step is higher than a temperature in the temporary bonding step.

12. The method for producing a semiconductor device according to claim 10,
wherein the temporary bonding step includes temporarily bonding the component B to be bonded to the component A to be bonded via the dry film by pressing and heating,
the permanent bonding step includes permanently bonding the component B to be bonded to the component A to be bonded by pressing and heating after temporarily bonding the component B to be bonded to the component A to be bonded in the temporary bonding step, and
a pressure in the permanent bonding step is higher than a pressure in the temporary bonding step.

13. The method for producing a semiconductor device according to claim 10,
wherein the temporary bonding step is performed in air, and the permanent bonding step is performed in an inert gas atmosphere.

14. The method for producing a semiconductor device according to claim 1 or 2, further comprising an application step including applying the paste containing at least one of a metal or a metal oxide onto the component A to be bonded,
wherein the dry film formation step includes drying the paste containing at least one of a metal or a metal oxide applied in the application step to form the dry film on the component A to be bonded.

15. The method for producing a semiconductor device according to claim 1 or 2, wherein the component A to be bonded is a substrate, and the component B to be bonded is a semiconductor chip.
